**Europäisches Patentamt**

**European Patent Office**

**Office européen des brevets**

(11) Publication number: **0 084 265**
**B1**

(12) **EUROPEAN PATENT SPECIFICATION**

(45) Date of publication of patent specification: **16.03.88**

(21) Application number: **82306973.7**

(22) Date of filing: **24.12.82**

(51) Int. Cl.⁴: **H 01 L 21/20,** H 01 L 21/268, H 01 L 21/263

(54) **Method of producing a semiconductor device comprising a plurality of recrystallized monocrystal regions.**

(30) Priority: **28.12.81 JP 211191/81**

(43) Date of publication of application:
**27.07.83 Bulletin 83/30**

(45) Publication of the grant of the patent:
**16.03.88 Bulletin 88/11**

(84) Designated Contracting States:
**DE FR GB**

(56) References cited:
**EP-A-0 030 286**
**EP-A-0 037 261**
**EP-A-0 041 776**

**IEDM INTERNATIONAL ELECTRON DEVICES MEETING, Washington, D.C., 3rd-5th December 1979, Technical Digest, no. 9.2, IEEE, New York, USA; H.-W. LAM et al.: "Device and circuit fabrication and physical characterization of pulsed-laser-annealed polysilicon on SiO2 and Si3N4"**

(73) Proprietor: **FUJITSU LIMITED**
**1015, Kamikodanaka Nakahara-ku Kawasaki-shi Kanagawa 211 (JP)**

(72) Inventor: **Ogawa, Tsutomu**
**1-21-8, Honkomagome**
**Bunkyo-ku Tokyo 113 (JP)**
Inventor: **Kamioka, Hajime**
**370-40, Kamikashio-cho Totsuka-ku Yokohama-shi Kanagawa 244 (JP)**
Inventor: **Kawamura, Seiichiro**
**2-26-9, Uehara**
**Shibuya-ku Tokyo 151 (JP)**
Inventor: **Sakurai, Junji**
**7-11, Seta 4-chome**
**Setagaya-ku Tokyo 158 (JP)**

(74) Representative: **Fane, Christopher Robin King et al**
**HASELTINE LAKE & CO. Hazlitt House 28 Southampton Buildings Chancery Lane London, WC2A 1AT (GB)**

Courier Press, Leamington Spa, England.

## Description

The present invention relates to a method for producing a semiconductor device, and more particularly to a method for producing a semiconductor device on a single crystalline region which is formed in a concave portion of an insulating layer by melting polycrystalline silicon or amorphous silicon to flow therein.

In one method for forming elements in a semiconductor device, proposed by the present inventors in Japanese Unexamined Patent Publication (Kokai) No. 55-98397 and Japanese Patent Application No. 56-154012 (filed September 30, 1981), concave portions are formed in an insulating layer formed on a substrate, a polycrystalline silicon layer is formed on the insulating layer and the polycrystalline silicon is melted by irradiation of the polycrystalline silicon layer with a laser or electron beam, by a lamp, or with another energy ray to cause the polycrystalline silicon to flow into the concave portions, thereby forming single crystalline regions therein.

The problem with this method is that while the upper surfaces of the resultant single crystalline regions in the concave portions should be level with the nonconcave portions of the insulating layer, this is difficult to achieve in practice. When the molten polycrystalline silicon flows into the concave portions, more tends to flow into some portions than others. This results in some single crystalline regions protruding above and other regions being recessed below the level of the nonconcave portions of the insulating layer. Further, some of the molten polycrystalline silicon may not flow into the concave portions but remains on nonconcave portions. This complicates the process of producing the semiconductor device.

It is an object of the present invention to provide a method for producing a semiconductor device wherein a plurality of single crystalline regions can be formed in concave portions of an insulating layer with the upper surfaces of the regions level with the nonconcave portions of the insulating layer.

It is another object of the present invention to provide a method for producing a semiconductor device wherein the isolation, single crystallization of silicon, and uniform distribution as well as activation of impurities implanted or doped into the polycrystalline silicon formed in the concave portions can be simultaneously carried out.

According to the present invention a method for producing a semiconductor device comprises the steps of: forming an insulating layer on a substrate, said insulating layer having a plurality of portions including a recess; forming a non-single crystalline silicon layer on the surface of said insulating layer; patterning said non-single crystalline silicon layer so that each of said portions is independently covered with a section of said patterned non-single crystalline silicon layer in an amount equal to the volume of the respective recess; melting and flowing said patterned non-single crystalline silicon layer into said recess by irradiation with an energy ray to form a single crystalline region in said recess and forming a semiconductor element in said single crystalline region.

The present invention will now be explained in more detail with reference to the accompanying drawings, in which:

Figs. 1A- to 1U are schematic cross-sectional views and Fig. 2 is a perspective view explaining an embodiment of the present invention and

Figs. 3 to 5 are schematic cross-sectional views explaining other embodiments of the present invention.

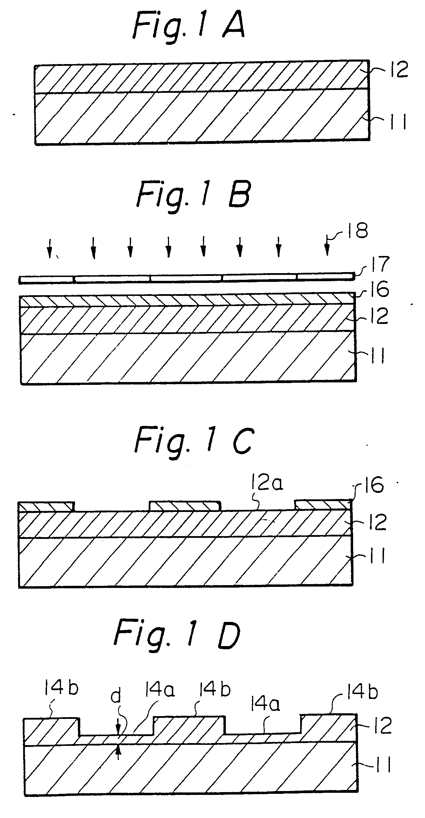

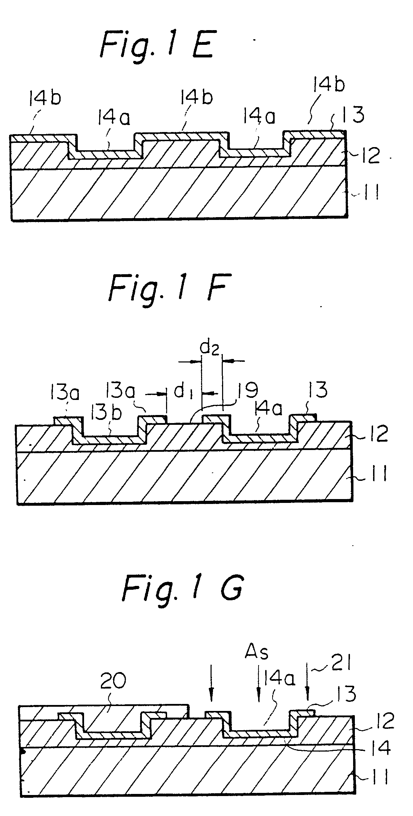

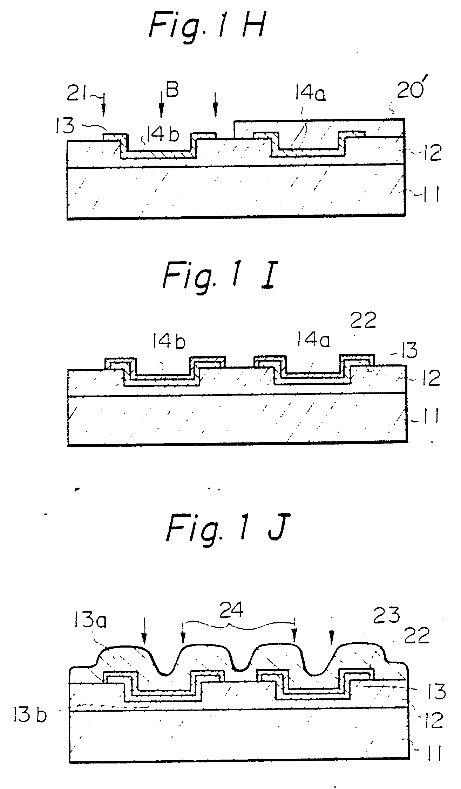

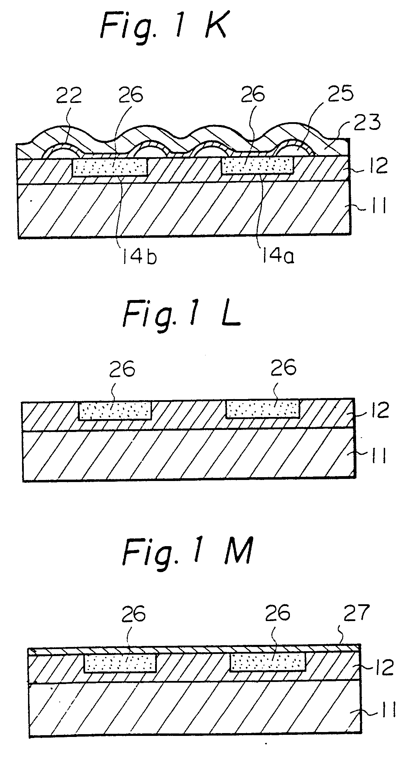

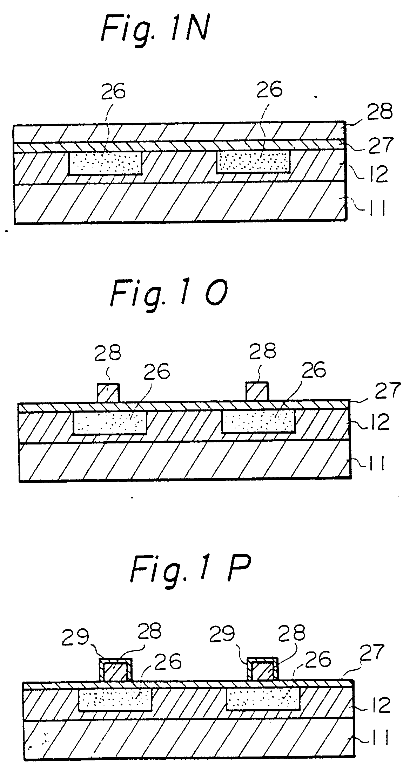

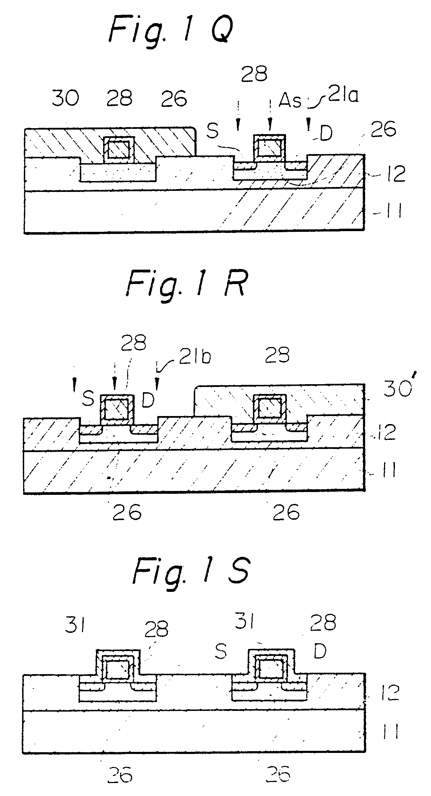

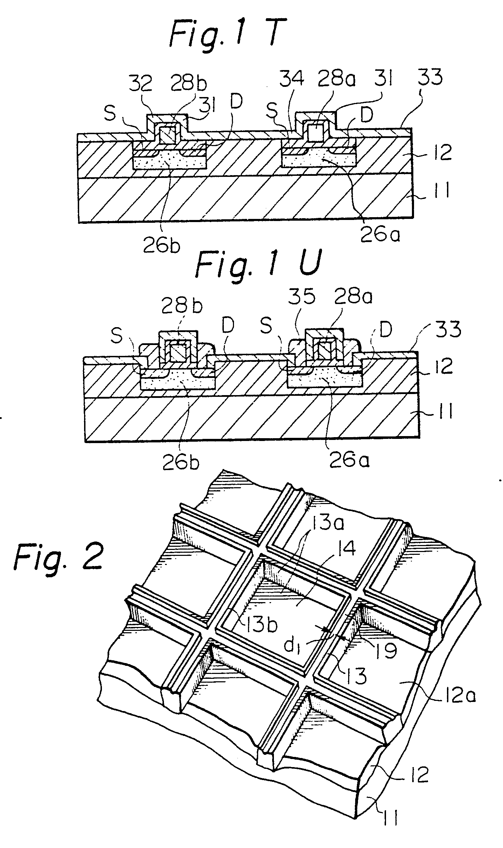

In the embodiment of the method according to the present invention illustrated in Figs. 1A to 1U and Fig. 2, an insulating layer 12 having a thickness of approximately 1 μm (micron) is first formed on a silicon substrate 11 (Fig. 1A). The insulating layer 12 is preferably silicon dioxide, silicon nitride or oxi-nitride, or alumina.

A photoresist layer 16 is formed on the insulating layer 12 and is exposed to ultraviolet rays or other energy rays 18 through a masking material 17, such as a glass mask (Fig. 1B).

The exposed region of the photoresist layer 16 is hardened by development thereof and the unexposed portion is removed, thereby forming exposed portions 12a of the insulating layer 12 (Fig. 1C).

Using the remaining photoresist layer 16 as a masking material, the exposed portions 12a of the insulating layer 12 are etched to form recesses 14a having a depth of, for example, 0.9 μm, i.e., a thickness (d) of 0.1 μm, and nonconcave portions 14b (Fig. 1D).

A silicon layer 13 having a thickness of, for example, 0.4 μm is formed on the entire surface of the insulating layer 12, including the recess 14a and nonconcave portions 14b, by a chemical vapor deposition (CVD) process (Fig. 1E). The silicon layer 13 is preferably polycrystalline silicon or amorphous silicon.

The silicon layer 13 is etched along the nonconcave portions 14b using, for example, a photoresist (not shown) as a masking material, to separate the layer 13 into different sections (Fig. 1F, Fig. 2). In the present invention, the width $d_1$ of the etched portion should be selected so that the amount of silicon in each section, i.e., the silicon remaining on the nonconcave portion 14b around each recess 14a (regions 13a), corresponding to the amount of width $d_2$, and the silicon in each recess 14a (regions 13b), equals the volume of the recess 14a. In this example, the width $d_1$ is selected to be 5 μm.

A photoresist layer 20 is formed on the silicon layer 13 of some recesses 14a to form P channel regions (left portion Fig. 1G) and phosphorus ions are implanted in the silicon layers 13 of other recesses 14a to form N channel regions (right portion in Fig. 1G).

The photoresist layer 20 is removed, another photoresist layer 20' is formed on the silicon layers 13 that are to form the N channel regions (right portion in Fig. 1H), and boron ions are implanted in the silicon layers 13 of the recesses 14a that are to form the P channel regions (left portion in Fig. 1H).

The photoresist layers 20' is then removed and the surfaces of the silicon layers 13 are oxidized to form polyoxide layers 22 (Fig. 1I). The polyoxide layers 22 prevent the doped ions from diffusing to portions other than the silicon layers 13.

CVD or other processes are then used to form a capping insulating layer 23 of phosphosilicate glass or other material of a thickness of approximately 1 μm over the entire surface of the insulating layer 12 and polyoxide layer 22. An energy ray 24, which may be a laser beam, an electron beam, an ion beam or from a lamp, carbon heater, etc., is then irradiated over the insulating layer 23 to the silicon layers 13. The region 13b of the silicon layers 13 in the recesses 14a of the insulating layers 12 melt earlier than the regions 13a on the nonconcave portions 14b because the former are in proximity to the silicon substrate 11, which acts as a heat sink (Fig. 1J).

The silicon of regions 13a next melts and flows into the recesses 14a, leaving cavities 25. It mixes with the silicon of regions 13b to form single-crystalline regions 26. Simultaneously, the previously implanted impurities for forming the N and P channel regions are uniformly distributed and activated (Fig. 1K).

The insulating layer 23 and polyoxide layer 22 are then removed. The upper surface of the regions 26 is substantially level with, for example only about 0.12 μm higher than, the nonconcave portions 14b of the insulating layer 12 (Fig. 1L).

After this, semiconductor elements, advantageously complementary metal oxide semiconductors (C-MOS), bipolar integrated circuits (IC), metal semiconductor or junction and field effect transistor semiconductor display devices can be formed on the regions 26. Taking a C-MOS for example, an insulating layer 27 of, for example, silicon dioxide of a thickness of 0.05 μm, is formed on the insulating layer 12 and the regions 26 (Fig. 1M).

Next, a silicon layer 28 of a thickness of, for example, about 0.3 μm is formed on the insulating layer 27 by a CVD or other process (Fig. 1N).

The silicon layer 28 is etched using a masking material (not shown) to form gate electrodes 28 on the insulating layer 27 (Fig. 1O).

The surfaces of the gate electrodes 28 are oxidized to form thereon silicon dioxide layers 29 having a thickness of approximately 0.1 μm (Fig. 1P).

A photo mask 30 is formed on the P channel region, (left side in Fig. 1Q), and a $5 \times 10^{15}$ ions cm² dose of arsenic ions 21a are implanted in the N channel regions (right side in Fig. 1Q) with 150 KeV to form source region S and drain region D of the MOS therein (Fig. 1Q).

The photo mask 30 is removed, another photo mask 30' is similarly formed on the N channel region and a $5 \times 10^{15}$ ions/cm² dose of boron ions 21b are implanted in the P channel region with 70 KeV to form source region S and drain region D therein (Fig. 1R).

The photo mask 30' is removed, and insulating layers 31 are formed on the source regions S, drain regions D and insulating layers 29 by annealing (Fig. 1S).

A polycrystalline silicon layer 33 of a thickness of approximately 1 μm is formed on the insulating layers 12 and 31 (Fig. 1T).

Finally, the polycrystalline silicon layer 33 is etched at portions 34 to make contact holes on the source regions S and drain regions D. Aluminum wirings 35 are formed on the source regions S and drain regions D through the contact holes 34 (Fig. 1U).

This completes the C-MOS.

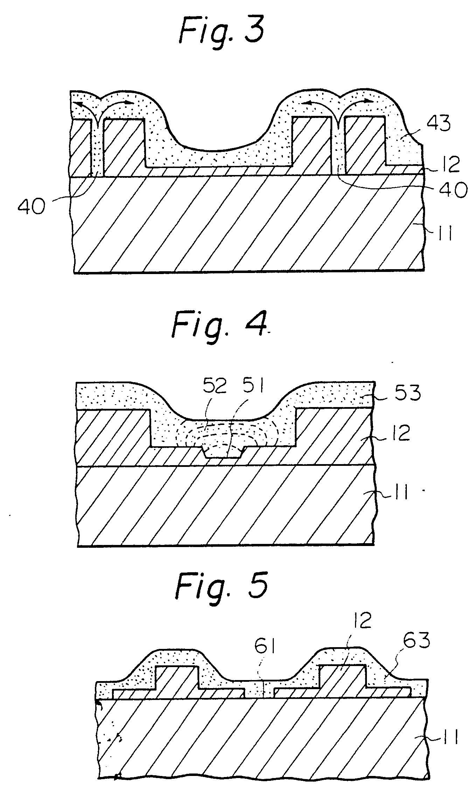

In another embodiment of the present invention, a hole 40 penetrating to the silicon substrate 11 may be formed in the convex portion 14b of insulating layer 12, as shown in Fig. 3, so that the silicon of layer 43 is single crystallized with the same crystal orientation as that of the silicon substrate 11.

Further, another recess 51 may be formed at the bottom of the recess 14a, as shown in Fig. 4, so that the silicon positioned in the recess 51 melts and cools earlier than that in other portions and forms the nucleus for larger single crystalline silicon.

Still further, a hole 61 penetrating to the silicon substrate 11 may be formed in the bottom of the recess 14a, as shown in Fig. 5, so that the area of the silicon substrate 11 positioned near the hole 61 forms the nucleus for single crystallization of the molten silicon.

As is clear from the above explanation, according to the present invention, the process for producing a semiconductor device can be remarkably shortened.

**Claims**

1. A method for producing a semiconductor device comprising the steps of: forming an insulating layer (12) on a substrate (11), said insulating layer having a plurality of portions each including a recess (14a); forming a non-single crystalline silicon layer (13) on the surface of said insulating layer (12), patterning said non-single crystalline silicon layer so that each of said portions is independently covered with a section (13a, 13b) of said patterned non-single crystalline silicon layer in an amount equal to the volume of the respective recess; melting and flowing said sections of the non-single crystalline silicon layer into the respective recesses by irradiation with an energy ray to form a single crystalline region in each said recess and forming semiconductor elements in said single single crystalline regions.

2. A method according to claim 1, wherein before the irradiation with said energy ray, impurities are introduced into said non-single crystalline silicon layer so that P type and N type regions are simultaneously formed by the irradiation.

3. A method according to any one of claim 2 wherein after introducing said impurities, a mask layer (22) for preventing diffusion of said impurities is formed on said non-single crystalline layer, a cap layer (23) is formed on said mask layer, and said energy ray is irradiated from above said cap layer.

4. A method according to any one of claims 1 to 3, wherein said non-single crystalline layer consisting of polycrystalline silicon or amorphous silicon.

5. A method according to any one of claims 1 to 4, wherein said energy ray is a laser beam, an electron beam or an ion beam.

## Patentansprüche

1. Verfahren zur Herstellung einer Halbleitervorrichtung mit folgenden Schritten: Bildung einer isolierenden Schicht (12) auf einem Substrat (11), welche isolierende Schicht eine Vielzahl von Bereichen hat, die jeweils eine Ausnehmung (14a) enthalten; Bildung einer nicht-einkristallinen Siliziumschicht (13) auf der Oberfläche der genannten isolierenden Schicht (12); Mustern der genannten nicht-einkristallinen Siliziumschicht, so daß jeder der genannten Bereiche unabhängig mit einem Abschnitt (13a, 13b) von der genannten gemusterten nicht-einkristallinen Siliziumschicht bedeckt wird, mit einer Menge, die gleich dem Volumen der jeweiligen Ausnehmung ist; Schmelzen und Fließen der genannten Abschnitte von der nicht-einkristalliner Siliziumschicht in die jeweiligen Ausnehmungen, durch Bestrahlen mit einem Energiestrahl, um eine einkristalline Region in jeder Ausnehmung zu bilden, und Bildung von Halbleiterelementen in den genannten einkristallinen Regionen.

2. Verfahren nach Anspruch 1, bei dem vor der Bestrahlung mit dem genannten Energiestrahl Verunreinigungen in die genannte nicht-einkristalline Siliziumschicht eingeführt werden, so daß P-Typ und N-Typ-Bereiche gleichzeitig durch die Einstrahlung gebildet werden.

3. Verfahren nach Anspruch 2, bei dem nach Einführung der genannten Verunreinigungen eine Maskenschicht (22) zur Verhinderung von Diffusion der genannten Verunreinigungen auf der genannten nicht-einkristallinen Schicht gebildet wird, eine Kappenschicht (23) auf der genannten Maskenschicht gebildet wird und der genannte Energiestrahl von oberhalb der genannten Kappenschicht eingestrahlt wird.

4. Verfahren nach einem der Ansprüche 1 bis 3, bei dem die genannte nicht-einkristalline Schicht aus polykristallinem Silizium oder amorphem Silizium besteht.

5. Verfahren nach einem der Ansprüche 1 bis 4, bei dem der genannte Energiestrahl ein Laserstrahl, ein Elektronenstrahl oder ein Ionenstrahl ist.

## Revendications

1. Procédé de fabrication d'un dispositif à semiconducteur, comprenant les étapes de formation d'une couche isolante (12) sur un substrat (11), la couche isolante ayant plusieurs parties comprenant chacune une cavité (14a) de formation d'une couche (13) de silicium non monocristallin à la surface de la couche isolante (12), de formation d'un dessin avec la couche de silicium non monocristallin de façon que chacune desdites parties soit indépendamment recouverte d'un tronçon (13a, 13b) de la couche de silicium non monocristallin formant un dessin, en quantité égale au volume de la cavité respective, de fusion et d'écoulement desdits tronçons de la couche de silicium non monocristallin dans les cavités respectives par irradiation par un rayonnement d'énergie, afin qu'une région monocristalline soit formée dans chaque cavité, et de formation d'éléments à semi-conducteur dans les régions monocristallines.

2. Procédé selon la revendication 1, dans lequel, avant l'irradiation par le rayonnement d'énergie, des impuretés sont introduites dans la couche de silicium non monocristallin afin que des régions de type P et de type N soient formées simultanément par l'irradiation.

3. Procédé selon l'une des revendications 2, dans lequel, après introduction des impuretés, une couche (22) formant un masque destiné à empêcher la diffusion des impuretés, est formée sur la couche non monocristalline, une couche de recouvrement (23) est formée sur la couche constituant le masque, et le rayonnement d'énergie irradie par dessus la couche de recouvrement.

4. Procédé selon l'une quelconque des revendications 1 à 3, dans lequel la couche non monocristalline est constituée de silicium polycristallin ou de silicium amorphe.

5. Procédé selon l'une quelconque des revendications 1 à 4, dans lequel le rayonnement d'énergie est un faisceau laser, un faisceau d'électrons ou un faisceau d'imns.

# Fig. 1 A

# Fig. 1 B

# Fig. 1 C

# Fig. 1 D

## Fig. 1 E

14b  14a  14b  14a  14b  13
12
11

## Fig. 1 F

$d_2$

13a  13a  $d_1$  19  13
13b  14a
12
11

## Fig. 1 G

20  As  21
14a
13
12
14
11

## Fig. 1 H

## Fig. 1 I

## Fig. 1 J

## Fig. 1 K

22  26            26       25
                           23
                           12
                           11

14b            14a

## Fig. 1 L

26            26
              12
              11

## Fig. 1 M

26       26       27
                  12
                  11

## Fig. 1N

26      26

28

27

12

11

## Fig. 1 O

28    26       28    26

27

12

11

## Fig. 1 P

29   28    29   28

26    26    27

12

11

## Fig. 1 Q

## Fig. 1 R

## Fig. 1 S

## Fig. 1 T

## Fig. 1 U

## Fig. 2

Fig. 3

Fig. 4

Fig. 5